# DEMANDE DE BREVET EUROPEEN

(11) **EP 1 156 591 A1**
(43) Date de publication de la demande: **21.11.2001**
(21) Numéro de dépôt: 01401259.5
(22) Date de dépôt: 15.05.2001
(51) Int. Cl.: H04B 1/38, G01R 29/08

(54) **Téléphone mobile perfectionné et procédé de paramétrage du téléphone**

(30) Priorité: 17.05.2000 FR 0006482
(71) Demandeur: SAGEM S.A., 75015 Paris (FR)
(72) Inventeur: Charbonnier, Philippe, 78600 Le Mesnil le Roi (FR)
(74) Mandataire: Schmit, Christian Norbert Marie

(57) **Abrégé**

On réalise un téléphone mobile (1) perfectionné dans le sens où il évalue le taux SAR à savoir la puissance absorbée thermiquement par une matière représentative des tissus biologiques placés contre le téléphone dans les conditions d'utilisation et il paramètre son fonctionnement suivant ce taux. On propose ainsi une solution qui garantit à l'utilisateur un usage du téléphone sans risque pour sa santé.

## Description

L'invention a pour objet un téléphone mobile perfectionné et un procédé de paramétrage de ce téléphone. Le domaine d'application est la téléphonie mobile comprise autant en communication de parole qu'en communication de données. Le but de l'invention est de perfectionner le téléphone mobile pour garantir à l'utilisateur un usage du téléphone sans risque pour sa santé.

Les téléphones mobiles émettent des radiations lors d'une communication. Les utilisateurs passent un temps croissant avec un téléphone mobile à l'oreille et des organismes de recherche évaluent des effets possibles sur sa santé. L'effet identifié à ce jour est l'échauffement thermique de zones du cerveau proches de l'appareil. On caractérise cet effet par la puissance absorbée thermiquement par une matière représentative des tissus biologiques placée contre l'appareil dans les conditions d'utilisation. Cette puissance définit la quantité SAR (Specific Absorption Rate - taux d'absorption spécifique). Pour la mesure de cette quantité SAR, on moyenne la puissance sur une période de 6 minutes imposée par l'ICNIRP (International Commission Non lonising Radio Protection). Cet organisme recommande de ne pas dépasser un taux SAR de 2 watts par kilo, si seule la tête est exposée aux radiations, et un taux SAR de 0,08 watts par kilo si l'ensemble du corps est exposé. La durée de 6 minutes est liée à l'activité sanguine du cerveau qui agit comme un fluide d'un radiateur de refroidissement.

Aujourd'hui les téléphones mobiles respectent les taux ICNIRP sans grande difficulté ni surcoût. En effet la puissance émise est actuellement au maximum de 2 watts tous les huitièmes du temps (en mode GSM TDMA) ce qui produit une absorption quasi acceptable d'emblée. Les constructeurs de téléphones mobiles apportent quelques améliorations par divers dispositifs, par exemple en favorisant un champ d'émission de l'antenne dans la direction opposée au cerveau, ou en écartant un peu l'antenne du cerveau.

On pourrait aussi envisager un émetteur métallique en forme de U produisant des radiations selon un champ magnétique tel que la région de la tête est évitée.

Aujourd'hui les téléphones mobiles respectent les taux SAR fixés mais dans un futur proche les téléphones mobiles pourront assurer des communications de données, par exemple GPRS, simultanément à des communications vocales. Dans ce cas, l'émission pouvant être permanente, la réduction au huitième ne se produira plus. On peut ainsi imaginer un ordinateur connecté à un téléphone mobile lui servant de modem. L'utilisateur consulte Internet et en même temps il reçoit un appel téléphonique. Des canaux de débit très supérieur à celui d'aujourd'hui seront utilisés. Eventuellement, il pourra être accepté des puissances plus grandes que les 2 watts observés aujourd'hui. Ou encore, l'emploi de microphone et de haut-parleur d'oreille en relation hertzienne avec un téléphone mobile peut conduire à des utilisations dangereuses, même si le téléphone mobile lui-même est éloigné. On peut aussi envisager que la réglementation fixera à l'avenir des valeurs plus sévères, non tenables économiquement avec les techniques actuelles. On peut alors craindre que les solutions actuelles ne soient plus suffisantes.

Selon l'invention, on règle ce problème en réalisant un téléphone mobile qui évalue le taux SAR de son utilisateur. De préférence, cette mesure permet au téléphone mobile de contrôler son utilisation (ou celle de ses accessoires). Par exemple le téléphone mobile limite ses émissions et /ou ses transmissions quand un seuil est atteint. La mesure sera de préférence cumulative et réalisée sur une durée glissant dans le temps (par exemple sur une durée de 6 minutes).

La puissance d'émission du téléphone mobile est normalement télécommandée par le réseau pour optimiser l'ensemble des communications en cours de la cellule où se trouve le téléphone. Comme les niveaux d'émission du téléphone sont calibrés et comme le réseau lui dicte quel niveau employer, un téléphone mobile sait en permanence avec quelle puissance il émet. Par des étalonnages en situation, le constructeur peut corréler la puissance émise à la puissance absorbée par le corps ou le cerveau, ce dernier étant la partie du corps la plus sensible aux rayonnements. Il peut ainsi se fixer des limites de puissance émise qui assurent le respect des limites de SAR. Le téléphone peut donc comparer sa puissance d'émission (moyennée sur six minutes dans une réalisation préférée) auxdites limites en tenant compte, dans le mode de réalisation préféré, de la proximité du cerveau. Il peut aussi comparer sa puissance d'émission aux limites fixées en tenant compte de la bande de fréquences considérée. Le résultat de cette comparaison détermine les mesures qui sont prises sur le fonctionnement du téléphone.

Le seul effet biologique connu à ce jour des ondes de radiotéléphone sur l'homme est l'échauffement thermique, qu'on a caractérisé par la notion de SAR. Il est possible que d'autres effets soient identifiés un jour, lié par exemple à la composante de champ électrique plutôt qu'à la puissance. Les constructeurs sauraient toujours faire une corrélation avec la puissance émise et il est probable que son cumul sur une certaine période de temps serait aussi déterminant. L'invention serait donc aussi applicable avec des seuils adéquats.

L'invention concerne donc un téléphone mobile caractérisé en ce qu'il comporte des moyens pour connaître la proximité du cerveau d'un utilisateur du téléphone mobile et des moyens pour évaluer une dose d'absorption de rayonnements que ledit téléphone mobile produirait dans les tissus biologiques de l'utilisateur, dans des conditions d'utilisation, l'évaluation de la dose de rayonnements prenant en compte la proximité ou non du cerveau de l'utilisateur.

L'invention concerne également un procédé de paramétrage d'un téléphone mobile caractérisé en ce que
- on mesure une énergie émise,
- on traite la mesure d'énergie émise pour la rendre représentative d'une dose reçue par l'utilisateur,
- on compare cette mesure traitée à un seuil,
- on détermine une limitation d'activité du téléphone en fonction d'un résultat de la comparaison.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :
- Figure 1 : un téléphone mobile conforme à l'invention ;
- Figure 2 : un algorithme préféré pour gérer la puissance absorbée par l'utilisateur pendant une durée de six minutes glissantes,
- Figure 3 : un algorithme préféré pour calculer la puissance absorbée pendant une durée de 3 secondes.

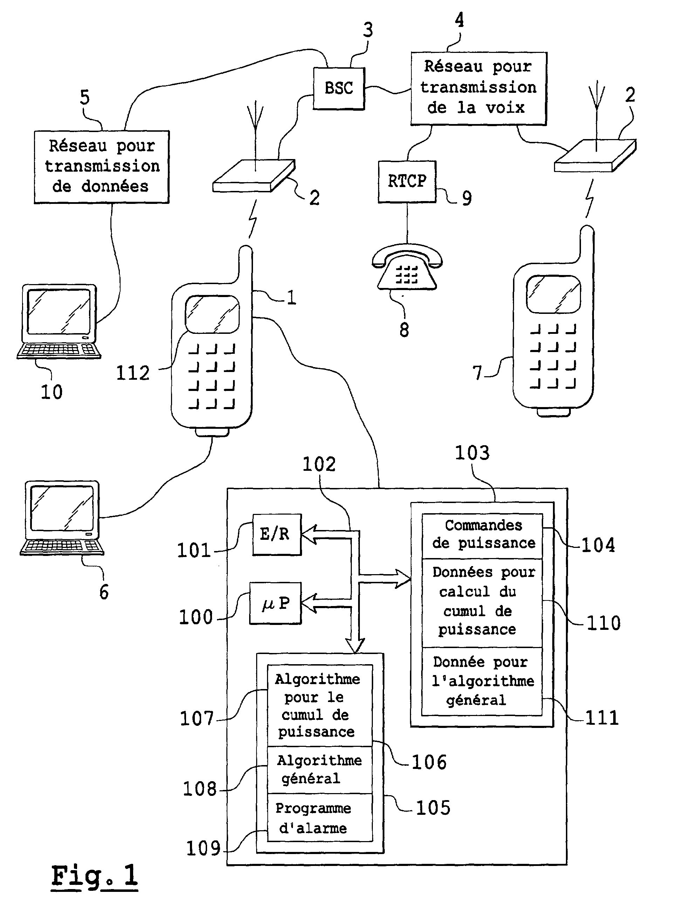

La figure 1 montre un téléphone mobile 1 capable par exemple d'établir et de gérer une communication vocale et une communication de données de manière simultanée. Le téléphone mobile 1 émet des ondes radioélectriques vers une station de base 2. Les stations de base du type de la station de base 2, avec lesquelles le téléphone mobile 1 communique, sont contrôlées par un contrôleur de stations de base 3 dit BSC. Suivant la nature de la communication, le contrôleur BSC 3 transmet des informations à un réseau 4 ou à un réseau 5. Le réseau 4 s'occupe par exemple de communications vocales selon un mode circuit, et le réseau 5 gère par exemple des communications de données selon un mode paquet.

Un utilisateur a par exemple connecté son téléphone mobile 1 à un ordinateur 6 et il consulte Internet. Des programmes consultés par l'utilisateur sur Internet sont hébergés, par exemple, sur un ordinateur serveur 10 relié au réseau 5. Pendant que l'utilisateur effectue sa consultation sur Internet, un appel téléphonique lui parvient. L'appel téléphonique peut provenir soit d'un téléphone mobile 7 soit d'un téléphone fixe 8. Le téléphone fixe 8 est relié à un réseau téléphonique commuté public 9 qui est lui-même relié au réseau 4. Le lien radioélectrique entre le réseau 4 et le téléphone mobile 7 est assuré par une station de base 2.

Le téléphone mobile 1, par exemple de type GSM 2 watts, est télécommandable en puissance de 20 milliwatts à 2 watts par pas de 2 décibels. Une commande de puissance, reçue par le téléphone 1 avec une périodicité de soixante millisecondes, est véhiculée par un canal dit SACCH et est traitée par des logiciels d'un microprocesseur général 100 du téléphone 1. Il est donc possible pour le téléphone mobile de connaître et de mémoriser dans une case mémoire la puissance qu'il émet au cours du temps.

Un émetteur récepteur 101 du téléphone mobile 1 est relié au microprocesseur 100 par l'intermédiaire d'un bus 102. Lorsque les réseaux 4 ou 5 transmettent au téléphone 1 la puissance avec laquelle celui-ci doit émettre, l'information est reçue par l'émetteur récepteur 101 qui, selon l'invention, la transmet à une mémoire de données 103 par l'intermédiaire du bus 102. Une information de commande de puissance est stockée dans un espace mémoire 104 de la mémoire de données 103.

Une mémoire programme 105 du téléphone mobile 1 contient selon l'invention un programme 106 gérant les taux SAR du téléphone 1. Plus généralement le programme 106 gère selon l'invention la puissance, instantanée ou moyenne, émise par le téléphone 1. Le programme 106 comporte notamment un premier sous-programme 107 qui contient un algorithme préféré permettant de calculer la puissance absorbée pendant une période de trois secondes. Un deuxième sous-programme 108 est mis en place dans le programme 106 et contient un algorithme préféré pour gérer la puissance absorbée par l'utilisateur sur une période de six minutes. Et un troisième sous-programme d'alarme 109, contenu dans le programme 106, met en place des mesures appropriées dans le cas où un seuil d'alarme S a été dépassé.

Des données pour des calculs de cumul de puissance sur une période de trois secondes sont mémorisées dans un espace mémoire 110 de la mémoire de données 103 et des données pour l'algorithme de gestion de la puissance absorbée sont mémorisées dans un espace mémoire 111 de cette mémoire 103.

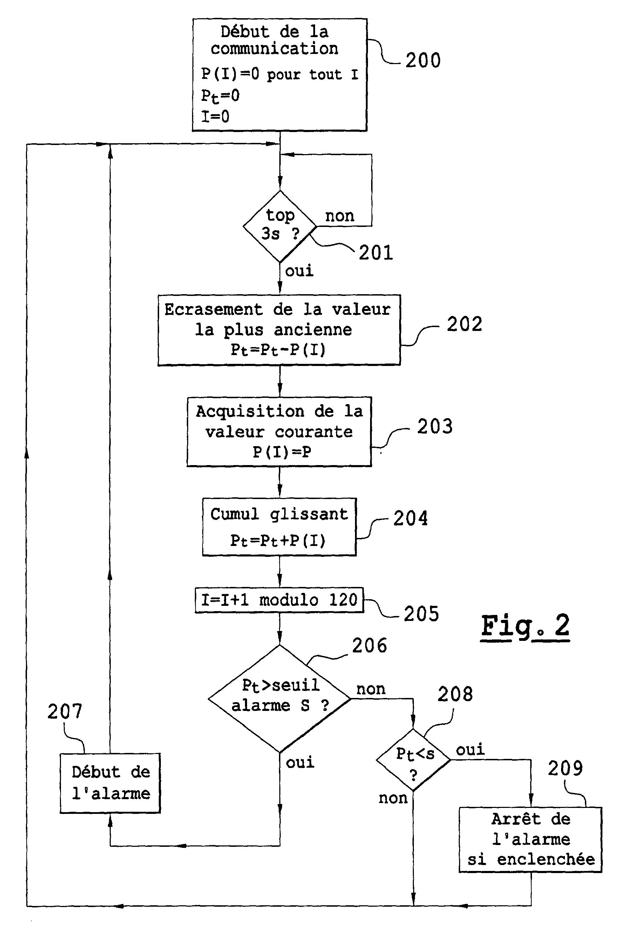

L'établissement d'au moins une communication pour le téléphone déclenche le programme 106. La figure 2 montre un algorithme préféré pour gérer la puissance absorbée par l'utilisateur pendant une période de six minutes glissantes.

Selon cet algorithme, lorsqu'une première communication est établie, on définit un état initial lors d'une étape 200 : une puissance absorbée indicée par un indice I, P(I), est nulle quel que soit I ; une puissance totale Pt est nulle ; l'indice I est nul au départ. Ensuite, au cours d'un test 201 on établit si un départ ou un top des trois secondes a été déclenché, c'est à dire si trois secondes se sont écoulées. Dans le cas où trois secondes ne se sont pas écoulées, aucune action n'est effectuée. On attend que trois secondes se soient écoulées. Si trois secondes se sont écoulées, on passe à une étape 202 au cours de laquelle on retranche à la puissance Pt une valeur ancienne P(I-6). La valeur P(I-6) est la valeur de puissance 6 minutes auparavant. Elle est nulle au démarrage de l'algorithme compte tenu de l'étape 200.

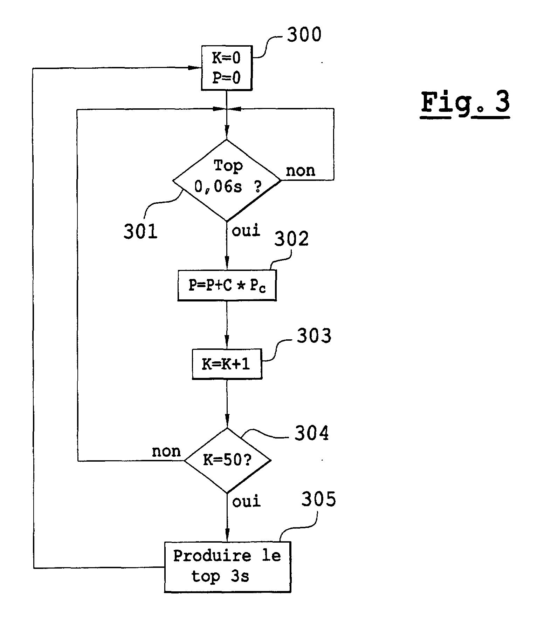

Puis au cours d'une étape 203, la puissance P(I) prend une valeur P de puissance courante. La valeur P de la puissance courante est de préférence déterminée grâce à un algorithme représenté sur la figure 3 et mis en place pendant les trois secondes du test 201.

En effet, des commandes de puissance arrivent toutes les soixante millisecondes en provenance de la station de base 2. On veut faire une moyenne glissante sur six minutes soit trois cent soixante secondes. On pourrait alors, selon une première variante mémoriser les six milles valeurs de puissance utilisées au cours des dernières trois cent soixante secondes, afin de faire une moyenne glissante. Dans cette variante, une nouvelle valeur de puissance prendrait dans la mémoire la place de la valeur de puissance la plus ancienne. Mais une telle démarche est inutilement précise et consommatrice de place en mémoire. Il est plus avantageux alors d'adopter une granularité plus grossière par exemple de grouper cinquante échantillons représentant trois secondes d'écoulement du temps. Cette granularité est établie grâce à l'algorithme de la figure 3. On obtient avec cet algorithme une valeur de puissance P de période.

L'algorithme de la figure 3 établit un calcul du cumul de la puissance P de période sur une période de trois secondes. Dans celui-ci, lors d'une étape 300, on initialise la puissance P de période et un indice d'incrémentation K respectivement à zéro.

Des commandes de puissance arrivant toutes les soixante millisecondes, on met en oeuvre un test 301 qui détermine si soixante millisecondes se sont écoulées. Dans le cas où le test 301 est positif, la puissance P de période mesurée est égale à une puissance P de période calculée précédemment incrémentée d'une puissance Pc courante. Dans un exemple la valeur Pc courante est celle qui vient d'être reçue de la station de base à titre de commande de puissance, et qui est mémorisée dans la mémoire de données 103, de préférence multipliée par un coefficient d'utilisation C. Le coefficient d'utilisation C est égal à un si l'appareil est près de l'oreille, et est négligeable devant un si l'appareil est loin de l'oreille. Il serait possible d'acquérir la valeur de puissance courante Pc d'autres manières, par exemple en mesurant le courant consommé par un amplificateur de sortie de l'émetteur récepteur. La solution préférée présente cependant l'avantage de ne nécessiter aucune réalisation matérielle supplémentaire du téléphone mobile.

Ensuite, lors d'une étape 303, on incrémente K de un. Puis on établit un test 304 qui détermine si K est égal à cinquante ou non. Dans le cas où K n'est pas égal à cinquante, on recommence les étapes de l'algorithme à partir du test 301. Dans le cas contraire, au cours d'une l'étape 305, on produit un signal de top de trois secondes qui intervient dans l'algorithme de la figure 2 en même temps qu'on dispose de la valeur P(I) à l'issue de la période I, ici de trois secondes.

Une étape 204 suivante de la figure 2 permet ensuite de calculer la puissance totale cumulée Pt. La puissance totale cumulée Pt est égale à la dernière valeur de la puissance Pt incrémentée de la valeur de la puissance P(I).

Ensuite, lors d'une étape 205 suivante, on incrémente de un l'indice I modulo 120. L'étape 205 permet de faire tourner le programme circulairement sur 120 positions. On effectue alors un test 206.

Au cours de ce test 206, on regarde si l'énergie totale cumulée pendant six minutes est supérieure à un seuil d'alarme S.

Si le seuil S est atteint ou dépassé, dans un cas préféré une alarme est déclenchée lors d'une étape 207. Au cours de l'étape 207 le sous-programme 109 est aussi déclenché. On retourne ensuite à l'étape 201.

Si la puissance totale Pt accumulée pendant les six dernières minutes n'est pas supérieure au seuil S, alors, lors d'un test 208, on regarde si Pt est inférieure à une limite inférieure s. La limite s est inférieure au seuil S. La limite s n'a de sens que dans le cas où le taux SAR calculé est réputé sensible, voire dangereux, pour la santé de l'utilisateur du téléphone 1. En effet, l'intervalle, caractérisé par le seuil S et le seuil s, définit une zone de danger pour l'utilisateur. Ainsi si le seuil S a été dépassé, l'alarme ne sera éteinte que si la puissance totale Pt est inférieure au seuil s.

Dans le cas où le test 208 est positif et que le programme d'alarme a été mis en marche, l'alarme est arrêtée au cours d'une étape 209 et on repasse ensuite à l'étape 201.

Dans le cas où le test 208 est négatif, on reprend l'algorithme à partir de l'étape 201.

L'algorithme permet d'établir une moyenne glissante. La puissance Pt est un cumul glissant car on lui retranche la valeur la plus ancienne (P(I) avant écrasement) et on lui ajoute la valeur la plus récente (P(I) après écrasement). Le test du seuil est établi en permanence et le taux SAR peut être affiché sur un écran 112 du téléphone 1. En variante, il peut être simplement précisé si on se trouve dans un état inférieur ou supérieur au seuil S. L'utilisateur peut ainsi connaître la puissance que sa tête est présumée absorber et il peut savoir si des conditions favorables pour sa santé sont respectées.

Le téléphone mobile 1 évalue selon l'invention un taux SAR dès l'établissement d'au moins une communication et limite son fonctionnement quand un seuil d'alarme S est atteint. Le seuil S peut être défini par un organisme de réglementation. Le téléphone 1 comptabilise alors l'énergie qu'il émet en tenant compte, dans le mode de réalisation préféré de l'invention, de la proximité du cerveau puis il compare l'énergie émise au cours d'une fenêtre glissante de six minutes au seuil S.

En effet, le téléphone mobile 1 peut savoir si le cerveau est proche ou éloigné dudit téléphone, et en particulier de l'antenne, de plusieurs façons. Il peut le constater directement, par exemple, grâce à un capteur acoustique, capacitif ou infrarouge situé à proximité de l'écouteur et donnant des indications sur la distance entre la tête de l'utilisateur et ce capteur.

Le téléphone 1 peut aussi déduire, de façon indirecte, la proximité de la tête de l'utilisateur et donc du cerveau de l'utilisateur. Cette méthode de déduction indirecte peut être basée sur plusieurs indices. Par exemple, comme le microphone du téléphone est proche de l'écouteur, on peut considérer que si le signal vocal reçu par le téléphone est fort, c'est que l'utilisateur est proche du microphone et donc proche de l'écouteur. Au contraire, si le signal vocal reçu est faible ou qu'il contient des réverbérations, alors cela signifie que l'utilisateur est éloigné du téléphone et qu'il utilise la fonction mains libres du téléphone. Un autre indice de déduction indirecte peut être de vérifier si l'option mains libres est activée ou pas. Cette option mains libres peut consister en l'activation d'un haut-parleur et d'un microphone sensible ou bien dans la connexion d'un ensemble piéton (appelé généralement « kit piéton ») constitué d'un casque avec micro écouteur. Dans ces deux cas d'option mains libres, l'antenne du téléphone est éloignée de la tête de l'utilisateur. Dans le cas où l'option mains libres comporte un haut-parleur à volume modifiable, on peut aussi regarder le niveau du volume sélectionné : plus le volume est élevé, plus le téléphone est éloigné de l'utilisateur, et inversement. Un autre indice peut être, aussi, de regarder si le volet de masquage du clavier est ouvert en position support sur table ; si c'est le cas, on en déduit que le téléphone est posé sur une table et, par conséquent, que l'antenne est éloignée de la tête de l'utilisateur.

Dans la détermination de la proximité du cerveau de l'utilisateur, il est important aussi de savoir s'il s'agit uniquement d'une communication vocale ou s'il s'agit d'une communication de données ou d'une communication de données et d'une communication vocale simultanées. On comprend que dans une communication de données pure, la puissance peut éventuellement être importante (par usage de plusieurs slots TDMA contre une seule en communication vocale) mais que l'utilisateur n'a aucune raison de mettre le téléphone contre sa tête; par contre en cas de communication de données simultanée à une communication vocale, le téléphone peut être contre la tête de l'utilisateur et la puissance encore plus importante sans que l'utilisateur en ait conscience.

D'autres méthodes peuvent encore être imaginées dans ce but de déterminer la proximité du cerveau de l'utilisateur. Ces méthodes peuvent être utilisées séparément ou, au contraire, conjointement de façon à en augmenter la fiabilité.

Par ailleurs, deux méthodes pour comptabiliser l'énergie sont envisageables. Une première méthode totalise l'énergie émise sur six minutes glissantes alors que l'appareil est près du cerveau. Quand on a atteint une limite L1, on considère que le taux SAR limite est atteint pour le cerveau et on prend des mesures appropriées. Une deuxième méthode totalise l'énergie émise sur six minutes que l'appareil soit près ou loin du cerveau. Quand une limite L2 est atteinte, on considère que le taux SAR limite pour l'ensemble du corps ( un autre taux, différent de celui pour la tête) sest atteint et on prend des mesures appropriées.

Les mesures et limites appropriées peuvent être de différentes natures, par exemple :
- Un avertissement de l'utilisateur qui reste maître de son destin. L'avertissement peut être, par exemple, un avertissement sonore. L'avertissement peut aussi se traduire par une diffusion saccadée des transmissions de parole et/ou de données pendant une durée déterminée,
- Un refus d'exécuter un appel vocal sortant ou entrant tant que l'énergie comptabilisée n'est pas redescendue en dessous d'une limite inférieure égale par exemple à la moitié de la limite L1,
- Un refus à exécuter une émission de données alors qu'une communication vocale en cours est déjà limite,
- Un ralentissement de la transmission de données, par exemple GPRS, simultanée à une communication vocale si la limite SAR est atteinte.

Le téléphone 1 réduit, tout seul, son débit d'émission GPRS. En effet, en technique GPRS, qui est une technique paquet, il est tout à fait naturel que l'émetteur (ici le mobile) soit maître des instants d'émission de ses paquets successifs. Le téléphone peut ainsi espacer ses paquets pour diluer dans le temps son énergie émise. Il peut aussi convenir avec le réseau de réduire le nombre de fenêtres TDMA employées.

Il serait aussi possible d'envisager une évaluation simplifiée de l'énergie, basée sur une puissance dite instantanée. Cette puissance dite instantanée serait une puissance moyenne sur une courte échelle, par exemple la seconde ou encore celle d'une trame TDMA.

Le téléphone 1 compare la puissance instantanée qu'il émet à un seuil (tenant compte ou pas de la proximité de la tête). Le téléphone 1 agit en conséquence sur son fonctionnement. Ce seuil de puissance est choisi pour que la quantité réglementaire (SAR) soit respectée assurément, alors qu'on ne sait pas si la puissance instantanée va être maintenue longtemps ou pas. Dans l'invention, pour prendre en compte le cas où elle est maintenue 6 minutes, le seuil en puissance est pris égal à un trois cent soixante soixantième de l'énergie émise réputée correspondre à l'énergie absorbée réglementaire.

Une telle implémentation est plus simple que l'implémentation décrite dans la réalisation préférée de l'invention. En effet cette autre implémentation ne nécessite pas de calculer un cumul. Mais elle génère des alertes ou des bridages d'émission plus fréquents car elle ne permet pas de respecter la réglementation au plus près.

Le téléphone mobile 1 évalue la puissance ou l'énergie émise : elle est corrélée au SAR absorbée par l'homme par des études du constructeur en laboratoire, et des seuils pareillement.

Quel que soit le mode de réalisation choisi, l'invention permet non seulement de déterminer les grandeurs électriques nécéssaires pour chiffrer la quantité de rayonnements reçus par l'utilisateur, mais elle permet aussi de transformer ces grandeurs électriques en des critères biologiques liés aux capacités naturelles de l'homme. En effet, le choix de la taille de la fenêtre glissante tient compte du comportement de la tête en absorption, notamment de la capacité du sang à évacuer les calories apportées au cerveau par les rayonnements émis par l'antenne du téléphone mobile.D'autre part, la correspondance entre grandeurs électriques et critère biologique a été étalonnée dans la phase d'étude de l'appareil et traduite dans le logiciel de l'appareil dans des seuils pratiques à employer.

## Revendications

1. Téléphone mobile (1) **caractérisé en ce qu'**il comporte des moyens pour connaître la proximité du cerveau d'un utilisateur du téléphone mobile et des moyens pour évaluer une dose d'absorption de rayonnements que ledit téléphone mobile produirait dans les tissus biologiques de l'utilisateur, dans des conditions d'utilisation, l'évaluation de la dose de rayonnements prenant en compte la proximité ou non du cerveau de l'utilisateur.

2. Téléphone selon la revendication 1, **caractérisé en ce que** la dose d'absorption est une énergie thermique absorbée (SAR).

3. Téléphone selon la revendication 1, **caractérisé en ce qu'**il comporte des moyens pour paramétrer son fonctionnement en fonction d'un résultat de l'évaluation.

4. Téléphone selon l'une des revendications 1 à 3, **caractérisé en ce qu'**il comporte des moyens pour réaliser simultanément une communication vocale et une communication de données.

5. Téléphone selon l'une des revendications 1 à 4, **caractérisé en ce qu'**il comporte des moyens pour afficher sur un écran (112) un taux d'absorption spécifique (SAR) ou un dépassement ou un non dépassement d'une limite par ce taux.

6. Procédé de paramétrage d'un téléphone mobile **caractérisé en ce que**
- on mesure une énergie émise,
- on traite la mesure d'énergie émise pour la rendre représentative d'une dose reçue par l'utilisateur,
- on compare cette mesure traitée à un seuil,
- on détermine une limitation d'activité du téléphone en fonction d'un résultat de la comparaison.

7. Procédé selon la revendication 6, **caractérisé en ce que**
- on mesure l'énergie émise par le téléphone pendant une durée glissante.

8. Procédé selon l'une des revendication 6 et 7, **caractérisé en ce que**
- on mesure une proximité d'un cerveau d'un utilisateur par rapport à ce téléphone.

9. Procédé selon la revendication 6, **caractérisé en ce que**
- on mesure une énergie émise à partir des consignes de puissance d'émission dictées par une station de base.

10. Procédé selon l'une des revendications 6 à 9, **caractérisé en ce que**
- on pondère (C) une mesure du taux SAR en fonction d'une proximité d'un cerveau d'un utilisateur.
